# EUROPÄISCHE PATENTSCHRIFT

(11) **EP 2 438 627 B1**
(45) Veröffentlichungstag und Bekanntmachung des Hinweises auf die Patenterteilung: **04.03.2020**
(21) Anmeldenummer: 10723082.3
(22) Anmeldetag: 21.05.2010
(51) Int. Cl.: H01L 33/38, H01L 33/44

(54) **OPTOELEKTRONISCHER HALBLEITERCHIP**
OPTOELECTRONIC SEMICONDUCTOR CHIP
PUCE SEMI-CONDUCTRICE OPTOELECTRONIQUE

(30) Priorität: 04.06.2009 DE 102009023849
(43) Veröffentlichungstag der Anmeldung: 11.04.2012
(73) Patentinhaber: OSRAM Opto Semiconductors GmbH, 93055 Regensburg (DE)
(72) Erfinder: MAUTE, Markus, 93053 Regensburg (DE); ENGL, Karl, 93080 Niedergebraching (DE)
(74) Vertreter: Epping - Hermann - Fischer
(86) Internationale Anmeldenummer: PCT/EP2010/057073
(87) Internationale Veröffentlichungsnummer: WO 2010/139567

(56) Entgegenhaltungen:
- WO-A1-2007/023419
- WO-A1-2008/069482
- WO-A2-2008/047325
- US-A- 6 084 175
- US-A1- 2005 056 855
- US-A1- 2005 133 807
- US-A1- 2005 281 303
- US-A1- 2006 289 883
- US-A1- 2007 096 130
- US-A1- 2007 176 188
- US-A1- 2008 145 961
- US-B2- 7 736 945

## Beschreibung

Die vorliegende Anmeldung betrifft einen optoelektronischen Halbleiterchip mit einem optoelektronischen Halbleiterkörper.

Aus den Dokumenten US 2008/0145961 A1, US 2007/176188 A1, WO 2007/023419 A1 und US 2006/0289883 A1 sind optoelektronische Halbleiterchips bekannt.
Es sind optoelektronische Halbleiterkörper bekannt, die eine Halbleiterschichtenfolge mit einer p-leitenden Schicht, einer strahlungsemittierenden aktiven Schicht und einer n-leitenden Schicht enthalten, wobei Sacklöcher durch die p-leitende Schicht und die aktive Schicht hindurch in die n-leitende Schicht verlaufen, durch welche hindurch die n-leitende Schicht elektrisch angeschlossen werden kann. Werden solche Halbleiterkörper mittels eines Lötmetalls auf eine Trägerplatte aufgebracht, besteht die Gefahr dass das Lötmetall die Sacklöcher nicht vollständig ausfüllt, sondern dass Hohlräume zwischen dem Halbleiterkörper und der Trägerplatte verbleiben. Der Halbleiterchip kann dann eine verringerte Effizienz haben oder vollständig unbrauchbar sein.

Es ist eine Aufgabe der vorliegenden Anmeldung, einen Halbleiterchip anzugeben, bei denen diese Gefahr reduziert ist.
Diese Aufgabe wird insbesondere durch einen Halbleiterchip gemäß dem unabhängigen Patentanspruch gelöst. Beispiele für vorteilhafte Weiterbildungen und Ausgestaltungen des Halbleiterchips sind in den abhängigen Patentansprüchen angegeben. Der Offenbarungsgehalt der Patentansprüche wird hiermit explizit durch Rückbezug in die Beschreibung aufgenommen.
Es wird ein optoelektronischer Halbleiterkörper angegeben. Der Halbleiterkörper hat eine Vorderseite, die zur Emission und/oder zum Empfang von elektromagnetischer Strahlung vorgesehen ist. Er hat zudem eine der Vorderseite gegenüberliegende Rückseite, die insbesondere zum Aufbringen auf eine Trägerplatte vorgesehen ist.
Der Halbleiterkörper weist eine aktive Halbleiterschichtenfolge auf, die insbesondere eine Folge anorganischer, vorzugsweise epitaktischer Halbleiterschichten ist. Die aktive Halbleiterschichtenfolge ist zur Emission und/oder zum Empfang elektromagnetischer Strahlung, insbesondere von infrarotem, sichtbarem und/oder ultraviolettem Licht, vorgesehen.
Die aktive Halbleiterschichtenfolge weist in Richtung von der Rückseite zur Vorderseite hin eine Schicht eines ersten Leitfähigkeitstyps, beispielsweise eine p-leitende Schicht, eine aktive Schicht und eine Schicht eines zweiten Leitfähigkeitstyps, zum Beispiel eine n-leitende Schicht, in dieser Reihenfolge auf. Die aktive Schicht enthält zweckmäßigerweise einen pn-Übergang, eine Doppelheterostruktur, eine Einfachquantentopfstruktur oder eine Mehrfachquantentopfstruktur zur Strahlungserzeugung und/oder zur Strahlungsdetektion.

Bei der erfindungsgemäßen Ausgestaltung weist die Halbleiterschichtenfolge mindestens eine Vertiefung auf, die sich von der Rückseite her in die Halbleiterschichtenfolge hinein erstreckt. Vorzugsweise weist sie eine Mehrzahl solcher Vertiefungen auf.

In der erfindungsgemäßen Ausgestaltung weist die Vertiefung einen ersten Abschnitt auf, welcher durch die Schicht des ersten Leitfähigkeitstyps und die aktive Schicht hindurch in die Schicht des zweiten Leitfähigkeitstyps hinein verläuft. Der erste Abschnitt hat eine Bodenfläche, die in der Schicht des zweiten Leitfähigkeitstyps angeordnet ist. Der erste Abschnitt enthält insbesondere einen rückseitigeren, an eine rückseitige Hauptfläche der Halbleiterschichtenfolge angrenzenden Randbereich der Vertiefung. Beispielsweise ist eine Öffnung des ersten Abschnitts in der rückseitigen Hauptfläche enthalten.

Die Vertiefung enthält zusätzlich einen zweiten Abschnitt. Der zweite Abschnitt weist eine Öffnung auf, welche in Draufsicht auf die Rückseite des Halbleiterkörpers von einer Außenkontur der Bodenfläche des ersten Abschnitts vollständig umschlossen ist. Ausgehend von seiner Öffnung erstreckt sich der zweite Abschnitt in Richtung zur Vorderseite des Halbleiterkörpers hin. Insbesondere verläuft er zumindest in der Schicht des zweiten Leitfähigkeitstyps. Bei einer bevorzugten Ausgestaltung weist der zweite Abschnitt eine Bodenfläche auf, die in der Schicht des zweiten Leitfähigkeitstyps angeordnet ist. Eine vorderseitige Bodenfläche der Vertiefung, vorzugsweise die Bodenfläche des zweiten Abschnitts, ist bei mindestens einer Ausgestaltung zumindest stellenweise mit einer Metallschicht bedeckt. Unter dem Begriff "Metallschicht" werden im Zusammenhang mit der vorliegenden Anmeldung Schichten und Schichtenfolgen verstanden, welche mindestens ein Metall und/oder eine Legierung von mindestens zwei Metallen enthalten oder daraus bestehen. Beispielsweise ist die Metallschicht eine Silberschicht oder eine Schichtenfolge aus einer Silberschicht und einer Goldschicht, wobei die Silberschicht insbesondere der Halbleiterschichtenfolge benachbart ist und die Goldschicht der Silberschicht in Richtung von der Halbleiterschichtenfolge weg nachfolgt.

Die Metallschicht ist beispielsweise elektrisch leitend Verbindung mit der Schicht des zweiten Leitfähigkeitstyps verbunden. Insbesondere ist die Metallschicht dazu vorgesehen, die Schicht des zweiten Leitfähigkeitstyps von der Rückseite her durch die Vertiefung hindurch elektrisch anzuschließen.

Bei einer Weiterbildung ist der zweite Abschnitt der Vertiefung zumindest teilweise mit der Metallschicht gefüllt. Beispielsweise ist der zweite Abschnitt vollständig mit der Metallschicht gefüllt.

Bei einer Variante dieser Weiterbildung ragt das Metall in Richtung der Rückseite über die Öffnung des zweiten Abschnitts hinaus. Beispielsweise ragt es säulenartig in den ersten Abschnitt hinein. In diesem Fall ist das Metall insbesondere in einem Mittelbereich des ersten Abschnitts angeordnet, während ein um den Mittelbereich umlaufender, insbesondere vollständig umlaufender, Randbereich frei von dem Metall ist.

Bei einer zweckmäßigen Ausgestaltung ist eine Oberfläche des ersten Abschnitts zumindest stellenweise mit einer elektrisch isolierenden Schicht, zum Beispiel mit einer dielektrischen Schicht, etwa einer SiO₂-Schicht oder einer Siliziumnitridschicht wie einer Si₃N₄-Schicht, überzogen. Vorzugsweise ist die Oberfläche des ersten Abschnitts zumindest im Bereich der Schicht des ersten Leitfähigkeitstyps und der aktiven Schicht mit der elektrisch isolierenden Schicht überzogen. Auf diese Weise wird die Gefahr eines Kurzschlusses der aktiven Schicht verringert. Bei einer weiteren zweckmäßigen Ausgestaltung ist die Oberfläche des zweiten Abschnitts - oder zumindest die Bodenfläche oder ein Teil der Bodenfläche des zweiten Abschnitts - frei von elektrisch isolierenden Schichten.

Gemäß zumindest einem Aspekt hat die Bodenfläche des ersten Abschnitts einen in Draufsicht auf die Rückseite vollständig um die Öffnung des zweiten Abschnitts umlaufenden Bereich, der eine minimale laterale Ausdehnung von größer oder gleich 1 µm, vorzugsweise von größer oder gleich 2 µm hat. Bei einer weiteren Ausgestaltung umschließt die Außenkontur der Bodenfläche des ersten Abschnitts ein Gebiet, dessen Flächeninhalt mindestens um ein Viertel größer ist als der Flächeninhalt der Öffnung des zweiten Abschnitts. Vorzugsweise ist der Flächeninhalt des von der Außenkontur der Bodenfläche des ersten Abschnitts umschlossenen Gebiets mindestens doppelt so groß wie der Flächeninhalt der Öffnung des zweiten Abschnitts.

Bei einer anderen Ausgestaltung hat der erste Abschnitt eine Tiefe von kleiner oder gleich 500 nm, beispielsweise eine Tiefe zwischen 200 nm und 400 nm, wobei die Grenzen eingeschlossen sind. Der zweite Abschnitt hat beispielsweise eine Tiefe von größer oder gleich 1 µm. Bei einer wiederum anderen Ausgestaltung ist die maximale laterale Ausdehnung der Öffnung des zweiten Abschnitts kleiner oder gleich drei Vierteln der maximalen lateralen Ausdehnung einer Außenkontur der Öffnung des ersten Abschnitts. Beispielsweise ist die maximale laterale Ausdehnung der Außenkontur der Öffnung des ersten Abschnitts größer oder gleich 50 µm. Die maximale laterale Ausdehnung der Öffnung des zweiten Abschnitts ist beispielsweise kleiner oder gleich 30 µm.

Gemäß zumindest einem Aspekt der vorliegenden Anmeldung wird ein optoelektronischer Halbleiterkörper angegeben, bei dem mindestens ein Drittel des Volumens der Vertiefung mit der Metallschicht gefüllt ist. Insbesondere erstreckt sich die Metallschicht von der vorderseitigen Bodenfläche der Vertiefung oder von der Bodenfläche des zweiten Abschnitts aus in Richtung zu der Rückseite hin.

Bei einer Ausgestaltung bedeckt die Metallschicht in Draufsicht auf die Rückseite einen Teilbereich, etwa einen mittleren Bereich, der vorderseitigen Bodenfläche. Insbesondere weist die Vertiefung einen um die Metallschicht umlaufenden Bereich auf, der frei von der Metallschicht ist.

Bei einer weiteren Ausgestaltung ragt die Metallschicht in Richtung der Rückseite über die Halbleiterschichtenfolge hinaus. Beispielsweise ragt in Draufsicht auf die Rückseite ein Randbereich der Metallschicht, insbesondere ein umlaufender Randbereich der Metallschicht, über die Vertiefung hinaus. Ein Mittelbereich der Metallschicht ragt beispielsweise nicht über die Halbleiterschichtenfolge hinaus.

Bei einer vorteilhaften Ausgestaltung des Halbleiterkörpers ist die Öffnung des zweiten Abschnitts in der Bodenfläche des ersten Abschnitts enthalten. Bei dieser Ausführungsform verläuft der zweite Abschnitt vorzugsweise vollständig innerhalb der Schicht des zweiten Leitfähigkeitstyps.

Bei einer alternativen Ausführungsform ist der erste Abschnitt als Rinne ausgebildet, die um die Öffnung des zweiten Abschnitts herum verläuft. Der zweite Abschnitt verläuft bei dieser Ausgestaltung vorzugsweise durch die Schicht des ersten Leitfähigkeitstyps und durch die aktive Schicht hindurch in die Schicht des zweiten Leitfähigkeitstyps hinein.

Insbesondere umschließt der erste Abschnitt in Draufsicht auf die Rückseite ein Gebiet der Halbleiterschichtenfolge vollständig, welches einen Mittelbereich und einen den Mittelbereich vollständig umschließenden Randbereich aufweist. Der erste Abschnitt stellt eine Rinne - mit anderen Worten: einen Graben - dar, die in den Randbereich enthalten ist und den Mittelbereich vollständig umschließt. Die Öffnung des zweiten Abschnitts ist insbesondere innerhalb des Mittelbereichs angeordnet.
Bei einer weiteren Ausgestaltung weist die Vertiefung, insbesondere der erste Abschnitt der Vertiefung eine Seitenfläche auf, die schräg zu einer Haupterstreckungsebene der Halbleiterschichtenfolge verläuft. Mit anderen Worten ist die Seitenfläche bezüglich der Haupterstreckungsebene geneigt. Unter einem "schrägen" oder "geneigten" Verlauf wird im Zusammenhang mit der vorliegenden Anmeldung verstanden, dass in mindestens einer Schnittebene, die von einer Oberflächennormalen auf einen Punkt der Seitenfläche und dem Normalenvektor auf die Haupterstreckungsebene aufgespannt werden, der Winkel zwischen der Seitenfläche und der Haupterstreckungsebene kleiner ist als 90°. Insbesondere ist er kleiner als 60°, beispielsweise beträgt er etwa 45°. Die Neigung ist insbesondere derart ausgebildet, dass sich die Vertiefung in Richtung von der Rückseite zur Vorderseite hin verjüngt.
Die Seitenfläche ist beispielsweise eine vollständig um die Vertiefung umlaufende Seitenfläche. Alternativ kann die Vertiefung auch eine Mehrzahl von Seitenflächen aufweisen - beispielsweise wenn sie eine rechteckige Kontur hat - welche gemeinsam die Vertiefung lateral begrenzen. Mindestens eine, bevorzugt jede dieser Seitenflächen verläuft beispielsweise zumindest im Bereich des ersten Abschnitts schräg zu der Haupterstreckungsebene der Halbleiterschichtenfolge.

Beispielsweise stellen die Seitenfläche oder die Seitenflächen im Bereich des ersten Abschnitts einen Kegelstumpf oder einen Pyramidenstumpf dar. Mittels solcher geneigt verlaufender Seitenflächen kann eine zuverlässige Bedeckung der aktiven Schicht mit der elektrisch isolierenden Schicht erleichtert werden, so dass die Gefahr eines Kurzschlusses der aktiven Schicht besonders gering ist.

Bei einer bevorzugten Weiterbildung verläuft die Seitenfläche oder die Seitenflächen des ersten Abschnitts flacher als die Seitenfläche oder die Seitenflächen des zweiten Abschnitts. Insbesondere verläuft die Seitenfläche oder die Seitenflächen des zweiten Abschnitts senkrecht oder zumindest nahezu senkrecht zur Haupterstreckungsebene der Halbleiterschichtenfolge. Beispielsweise ist in mindestens einer Schnittebene, vorzugsweise in allen Schnittebenen, die von einer Oberflächennormalen auf einen, insbesondere beliebigen Punkt der Seitenfläche und dem Normalenvektor auf die Haupterstreckungsebene aufgespannt werden, der Winkel zwischen der Seitenfläche und der Haupterstreckungsebene größer oder gleich 70°, zum Beispiel größer oder gleich 80°.

Bei einer weiteren Ausgestaltung hat die Vertiefung in Draufsicht auf die Rückseite einen kreuzförmigen Querschnitt oder einen sternförmigen Querschnitt. Bei einer solchen Formgebung kann mit Vorteil ein im Vergleich zum Flächeninhalt der vorderseitigen Bodenfläche, insbesondere zur Bodenfläche des zweiten Abschnitts, besonders kleines Volumen der Vertiefung erzielt werden.
Bei einer Weiterbildung weist der Halbleiterkörper eine Mehrzahl von Vertiefungen mit kreuzförmigem oder sternförmigem Querschnitt auf, die beispielsweise an den Gitterpunkten eines gedachten Gitters - etwa eines rechteckigen oder quadratischen Gitters - angeordnet sind. Zwischen zwei, insbesondere zwischen je zwei, der kreuzförmigen oder sternförmigen Vertiefungen ist bei einer Weiterbildung eine streifenförmige Vertiefung angeordnet. Eine "streifenförmige" Vertiefung hat insbesondere in Draufsicht auf die Rückseite in zwei zueinander senkrechten Richtungen maximale laterale Ausdehnungen, die sich um einen Faktor von größer oder gleich 2, beispielsweise um einen Faktor von größer oder gleich 5, unterscheiden.
Gemäß einem weiteren Aspekt der vorliegenden Anmeldung wird ein optoelektronischer Halbleiterchip angegeben, der einen optoelektronischen Halbleiterkörper mit einer Vertiefung oder einer Mehrzahl von Vertiefungen aufweist wie oben beschrieben.
Zusätzlich weist der Halbleiterchip bei einer Ausgestaltung eine Trägerplatte auf, die Beispielsweise Si oder Ge enthält oder daraus besteht. In diesem Fall ist vorzugsweise die Rückseite des Halbleiterkörpers der Trägerplatte zugewandt.

Der Halbleiterkörper ist bei der erfindungsgemäßen Ausgestaltung mittels eines Lötmetalls an der Trägerplatte befestigt. Das Lötmetall füllt die Vertiefung aus. Gemäß der vorliegenden Erfindung füllt das Lötmetall zumindest den ersten Abschnitt der Vertiefung aus. Vorzugsweise ist das Lötmetall von dem Material der Metallschicht verschieden. Als Lötmetall ist beispielsweise AuSn, AuIn oder In verwendet.

Dass das Lötmetall die Vertiefung / den ersten Abschnitt "ausfüllt" bedeutet insbesondere, dass der von der Vertiefung /dem ersten Abschnitt umschlossene Bereich mit dem Lötmetall gefüllt ist, insbesondere vollständig gefüllt ist, soweit er von der elektrisch isolierenden Schicht und der Metallschicht frei gelassen ist. Bei Ausgestaltungen, in denen die Vertiefung, insbesondere der zweite Abschnitt der Vertiefungen, eine Metallschicht enthält, und/oder die Vertiefung, insbesondere der erste Abschnitt der Vertiefung, eine elektrisch isolierende Schicht enthält, ist somit darunter insbesondere zu verstehen, dass das Lötmetall den von der Metallschicht und/oder der elektrisch isolierenden Schicht frei gelassenen Bereich der Vertiefung ausfüllt. Beispielsweise bei einer Ausgestaltung, bei der die Metallschicht einen Teilbereich der vorderseitigen Bodenfläche der Vertiefung bedeckt ist ein um die Metallschicht umlaufender Bereich der Vertiefung mit dem Lötmetall gefüllt.

Das Volumen der Vertiefung, insbesondere das von der Metallschicht frei gelassene Volumen der Vertiefung ist mit Vorteil bei den Halbleiterkörpern gemäß der vorliegenden Anmeldung besonders gering. Beispielsweise beträgt es 1000 µm³ oder weniger, insbesondere 500 µm³ oder weniger. Beispielsweise beträgt es zwischen 300 µm³ und 500 µm³, wobei die Grenzen eingeschlossen sind. Auf diese Weise ist insbesondere die Gefahr reduziert, dass bei der Herstellung der Halbleiterchips Hohlräume in der Vertiefung verbleiben, welche nicht mit Lötmetall gefüllt werden. Somit ist insbesondere auch die Gefahr einer verringerten Effizienz oder Unbrauchbarkeit des Halbleiterchips verringert.

Bei einer weiteren vorteilhaften Ausgestaltung ist zwischen der Metallschicht und dem Lötmetall eine Lötstoppschicht, die beispielsweise TiWN enthält, angeordnet. Die Lötstoppschicht ist insbesondere dazu vorgesehen, eine Vermischung des Lötmetalls mit der Metallschicht zu vermindern oder zu verhindern. Bei einer Weiterbildung ist die Lötstoppschicht zumindest über der gesamten Oberfläche der Vertiefung und insbesondere vollflächig über der rückseitigen Hauptfläche des Halbleiterkörpers angeordnet.

Gemäß einem weiteren Aspekt der vorliegenden Anmeldung ragt bei dem Halbleiterkörper die Schicht des zweiten Leitfähigkeitstyps seitlich über die aktive Schicht und die Schicht des ersten Leitfähigkeitstyps hinaus. Insbesondere bildet die Schicht des zweiten Leitfähigkeitstyps einen lateral um die Halbleiterschichtenfolge umlaufenden Vorsprung.

Vorzugsweise bildet bei dem Halbleiterchip die Schicht des zweiten Leitfähigkeitstyps auf diese Weise zusammen mit der Trägerplatte eine um die Halbleiterschichtenfolge umlaufende Nut, durch welche die Haupterstreckungsebene der aktiven Schicht verläuft. Die Nut ist bei einer Ausgestaltung mit dem Lötmetall gefüllt. Vorzugsweise ist die Ausdehnung der Nut in Richtung von der Vorderseite zur Rückseite kleiner oder gleich 500 nm. Bei einer derartigen Ausdehnung ist die Gefahr der Bildung von Hohlräumen innerhalb der Nut, welche frei von dem Lötmetall sind, mit Vorteil besonders gering.

Ein Oberflächenbereich der Halbleiterschichtenfolge ist zumindest im Bereich der Nut bei einer Ausgestaltung mit einer Passivierungsschicht versehen. Die Passivierungsschicht ist insbesondere zwischen der Halbleiterschichtenfolge und dem Lötmetall angeordnet. Bei einem solchen Halbleiterchip ist die aktive Schicht nach dem Aufbringen des Halbleiterkörpers auf die Trägerplatte vorteilhafterweise besonders gut geschützt. Beispielsweise braucht bei nachfolgenden Prozessschritten zur Herstellung des Halbleiterchips - etwa dem Ätzen von Mesas in die Halbleiterschichtenfolge - die aktive Schicht mit Vorteil nicht frei gelegt zu werden.

Bei einer Ausgestaltung des Halbleiterchips ragt ein Randbereich der Trägerplatte seitlich über die Halbleiterschichtenfolge hinaus. Insbesondere erstreckt sich die Passivierungsschicht seitlich von der Halbleiterschichtenfolge zumindest über einen Teil des Randbereichs der Trägerplatte, derart dass die mit Lötmetall gefüllte Nut seitlich über die Halbleiterschichtenfolge hinaus verlängert ist.

Bei einer Weiterbildung verläuft die Passivierungsschicht in Richtung von einem Mittelbereich zu einer Kante der Trägerplatte hin zunächst zur Bildung der Nut in Richtung der Vorderseite von der Trägerplatte weg und nachfolgend wieder in Richtung zu der Trägerplatte hin. Vorzugsweise verläuft die Passivierungsschicht in Richtung von dem von der Halbleiterschichtenfolge überdeckten Mittelbereich zu der Kante der Trägerplatte hin zunächst in dem Mittelbereich zur Bildung der Nut in Richtung der Vorderseite von der Trägerplatte weg und nachfolgend in dem Randbereich der Trägerplatte wieder in Richtung zu der Trägerplatte hin. Die Nut erstreckt sich auf diese Weise in lateraler Richtung über ein Teilstück des Randbereichs, aber vorzugsweise nicht bis zur Kante des Trägersubstrats hin. Auf diese Weise ist das mit dem Lötmetall zu füllende Volumen der Nut vorteilhafterweise besonders gering.

Gemäß einem weiteren Aspekt der vorliegenden Anmeldung wird ein Verfahren zum Herstellen eines Halbleiterchips angegeben.

Bei einer bevorzugten Ausgestaltung des Verfahrens ist der bereitgestellte optoelektronische Halbleiterkörper von einem die Halbleiterschichtenfolge aufweisenden Halbleiterwafer umfasst, welcher in einem nachfolgenden Verfahrensschritt in eine Mehrzahl von Halbleiterkörpern aufgeteilt wird, zum Beispiel mittels Ätzen von Mesas. Die Trägerplatte ist beispielsweise von einem Trägerplattenwafer umfasst, der in einem nachfolgenden Verfahrensschritt in einzelne Trägerplatten aufgeteilt wird, zum Beispiel mittels Lasertrennen. Das Verfahren ist im Folgenden anhand eines Halbleiterkörpers und einer Trägerplatte beschrieben. Stattdessen kann jeweils auch ein Halbleiterwafer und/oder ein Trägerplattenwafer verwendet werden.

Bei einem ersten Schritt des Verfahrens werden der optoelektronische Halbleiterkörper und die Trägerplatte bereitgestellt.

Die Rückseite des Halbleiterkörpers oder eine Fläche der Trägerplatte wird bei einem weiteren, insbesondere nachfolgenden Verfahrensschritt mit dem Lötmetall versehen. Alternativ kann die Rückseite des Halbleiterkörpers mit einem ersten Bestandteil des Lötmetalls und eine Fläche der Trägerplatte mit einem zweiten Bestandteil des Lötmetalls versehen werden.

In einem nachfolgenden Verfahrensschritt wird der Halbleiterkörper so auf der Trägerplatte angeordnet, dass seine Rückseite dem Trägerplatte zugewandt ist und das Lötmetall, beziehungsweise der erste und zweite Bestandteil des Lötmetalls zwischen Halbleiterkörper und Trägerplatte angeordnet ist.

Bei einer Ausgestaltung des Verfahrens wird die Vertiefung oder der erste Abschnitt der Vertiefung zumindest teilweise mit einer Metallschicht aus einem von dem Lötmetall verschiedenen Material gefüllt, bevor der Halbleiterkörper auf der Trägerplatte angeordnet wird.

In einem nachfolgenden Verfahrensschritt wird eine mechanisch stabile Verbindung zwischen dem Halbleiterkörper und der Trägerplatte hergestellt, wobei das Lötmetall geschmolzen wird. Bei diesem Verfahrensschritt füllt das Lötmetall die Vertiefung oder die Vertiefungen in dem Halbleiterkörper aus. Ist ein erster Bestandteil des Lötmetalls auf den Halbleiterkörper und ein zweiter Bestandteil des Lötmetalls auf die Trägerplatte aufgebracht worden, vermischen sich beide Bestandteil bei diesem Verfahrensschritt insbesondere zu dem Lötmetall.

Weitere Vorteile und vorteilhafte Ausgestaltungen und Weiterbildungen des Halbleiterkörpers, des Halbleiterchips und des Verfahrens ergeben sich aus den folgenden, in Zusammenhang mit den Figuren 1 bis 13 erläuterten exemplarischen Ausführungsbeispielen.

Es zeigen:
Figur 1, einen schematischen Querschnitt durch einen optoelektronischen Halbleiterkörper bei einem ersten Stadium eines exemplarischen Ausführungsbeispiels eines Verfahrens zu seiner Herstellung,
Figur 2, einen schematischen Querschnitt durch den Halbleiterkörper bei einem zweiten Stadium des Verfahrens,
Figur 3, einen schematischen Querschnitt durch den Halbleiterkörper bei einem dritten Stadium des Verfahrens,
Figur 4, einen schematischen Querschnitt durch den Halbleiterkörper bei einem vierten Stadium des Verfahrens,
Figur 5, einen schematischen Querschnitt durch den Halbleiterkörper bei einem fünften Stadium des Verfahrens,
Figur 6, einen optoelektronischen Halbleiterchip gemäß einem ersten Ausführungsbeispiel,
Figuren 7A, 7B und 7C, exemplarische Ausführungsbeispiele von Vertiefungen in der Halbleiterschichtenfolge des optoelektronischen Halbleiterkörpers gemäß dem ersten Ausführungsbeispiel in schematischen Draufsichten auf einen Ausschnitt von dessen Rückseite,
Figur 8, einen schematischen Querschnitt durch einen optoelektronischen Halbleiterkörper gemäß einem zweiten Ausführungsbeispiel,
Figur 9, eine schematische Draufsicht auf einen Ausschnitt der Rückseite des optoelektronischen Halbleiterkörpers gemäß dem zweiten exemplarischen Ausführungsbeispiel,
Figur 10, einen schematischen Querschnitt durch einen optoelektronischen Halbleiterchip gemäß einem ersten nicht zur Erfindung gehörenden Erläuterungsbeispiel
Figur 11, einen schematischen Querschnitt durch einen optoelektronischen Halbleiterchip gemäß einem zweiten nicht zur Erfindung gehörenden Erläuterungsbeispiel
Figur 12, einen schematischen Querschnitt durch einen optoelektronischen Halbleiterchip gemäß einem dritten, nicht zur Erfindung gehörenden Erläuterungsbeispiel, und
Figur 13, einen schematischen Querschnitt durch einen optoelektronischen Halbleiterchip gemäß einem vierten, nicht zur Erfindung gehörenden Erläuterungsbeispiel.

In den Ausführungsbeispielen, den Erläuterungsbeispielen und Figuren sind ähnliche oder ähnlich wirkende Elemente mit den gleichen Bezugszeichen versehen. Die Figuren und die Größenverhältnisse der in den Figuren gezeigten Elemente untereinander sind nicht als maßstäblich zu verstehen. Vielmehr können einzelne Elemente, zum Beispiel Schichten, zum besseren Verständnis und/oder zur besseren Darstellbarkeit übertrieben groß dargestellt sein.

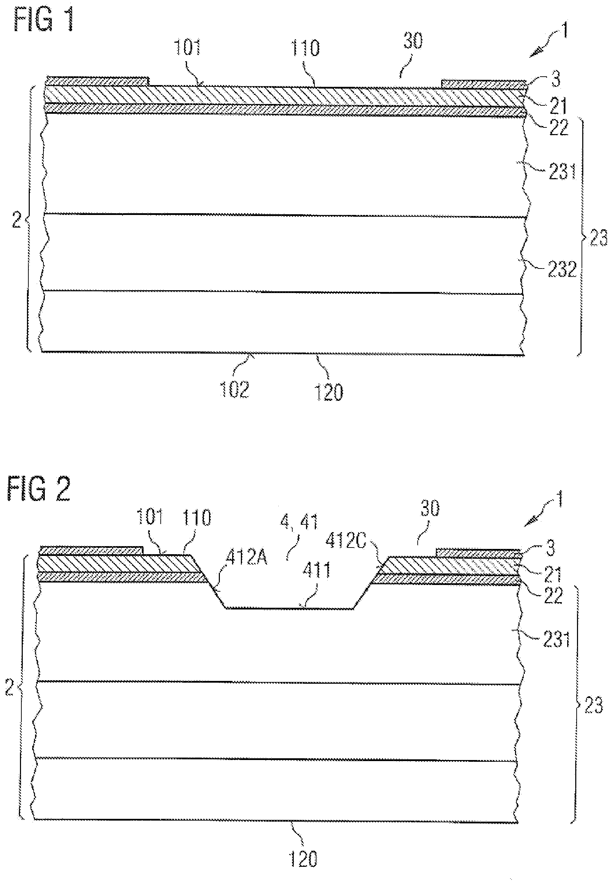

Figur 1 zeigt einen schematischen Querschnitt durch einen optoelektronischen Halbleiterkörper gemäß einem ersten exemplarischen Ausführungsbeispiel bei einem ersten Stadium eines exemplarischen Ausführungsbeispiels eines Verfahrens zu seiner Herstellung.
Der Halbleiterkörper 1 weist eine aktive Halbleiterschichtenfolge 2 auf. Die Halbleiterschichtenfolge 2 enthält eine Schicht eines ersten Leitfähigkeitstyps, vorliegend eine p-leitende Schicht 21. Zudem enthält die Halbleiterschichtenfolge 2 eine aktive Schicht 22, die beispielsweise eine Mehrfachquantentopfstruktur zur Strahlungserzeugung aufweist. Zusätzlich enthält die Halbleiterschichtenfolge 2 eine Schicht eines zweiten Leitfähigkeitstyps, vorliegend eine n-leitende Schicht 23.

Die p-leitende Schicht 21, die aktive Schicht 22 und die n-leitende Schicht 23 folgen in dieser Reihenfolge von einer Rückseite 110 zu einer Vorderseite 120 des Halbleiterkörpers 1 hin in dieser Reihenfolge aufeinander. Der optoelektronische Halbleiterkörper 1 ist gemäß diesem ersten exemplarischen Ausführungsbeispiel zur Emission von sichtbarem Licht von seiner Vorderseite 120 vorgesehen. Es ist auch denkbar, dass die n-Seite und die p-Seite vertauscht sind, so dass in Richtung von der Rückseite 110 zur Vorderseite 120 hin die n-leitende Schicht, die aktive Schicht und die p-leitende Schicht in dieser Reihenfolge aufeinander folgen.

Die n-leitende Schicht 23 hat vorliegend einen optionalen ersten Bereich 231, der einen n-Dotierstoff in einer ersten Konzentration enthält und einen optionalen zweiten Bereich 232, der einen n-Dotierstoff in einer zweiten Konzentration enthält. Der erste Bereich 231 ist zwischen der aktiven Schicht 22 und dem zweiten Bereich 232 angeordnet. Die zweite Konzentration ist größer als die erste Konzentration. Insbesondere ist sie mindestens fünfmal so groß wie die erste Konzentration. Beispielsweise beträgt die erste Konzentration zwischen 0 und 5 x 10¹⁸ Atome pro Kubikzentimeter, wobei die Grenzen eingeschlossen sind. Die zweite Konzentration ist vorzugsweise größer oder gleich 5 x 10¹⁸ Atome pro Kubikzentimeter, besonders bevorzugt größer oder gleich 1 x 10¹⁹ Atome pro Kubikzentimeter.

Auf eine rückseitige Hauptfläche 101 der Halbleiterschichtenfolge 2 ist eine erste metallische Kontaktschicht 3 aufgebracht. Vorliegend handelt es sich bei der ersten metallischen Kontaktschicht um eine p-Kontaktschicht 3.

Die p-Kontaktschicht 3 ist strukturiert aufgebracht oder wird nach dem Aufbringen strukturiert, so dass sie eine Mehrzahl von Aussparungen 30 aufweist, von denen eine in Figur 1 gezeigt ist.

Figur 2 zeigt ein zweites Stadium des Verfahrens, nach dem bei einem Verfahrensschritt im Bereich der Aussparungen 30 der p-Kontaktschicht 3 Vertiefungen 4 in der Halbleiterschichtenfolge 2 hergestellt worden sind. Bei dem Ausführungsbeispiel der Figur 2 wird bei diesem Verfahrensschritt in einem Mittelbereich der Aussparungen 30 Material der Halbleiterschichtenfolge abgetragen, um die Vertiefung 4 herzustellen, während in einem Randbereich der Aussparung 30 kein Material der Halbleiterschichtenfolge 2 abgetragen wird, so dass der Randbereich von der Vertiefung 4 nicht betroffen ist.

Alternativ kann sich die Vertiefung 4 lateral über den gesamten Bereich der Aussparung 30 erstrecken. Dies ist beispielsweise vorteilhaft, wenn die p-Kontaktschicht 3 erst nach dem Aufbringen auf die Halbleiterschichtenfolge 2 mit den Aussparungen 30 versehen wird. In diesem Fall kann eine Maskenschicht, die beispielsweise zum Herstellen der Aussparungen 30 auf die p-Kontaktschicht 3 aufgebracht wird auch als Maskenschicht für die Herstellung der Vertiefung 4 dienen. Beispielsweise handelt es sich bei der Maskenschicht um eine Fotolackschicht und die Strukturierung der p-Kontaktschicht 3 und/oder die Herstellung der Vertiefungen 4 umfasst einen Fotolithographie-Schritt.

Der erste Abschnitt 41 der Vertiefung 4 streckt sich von der Rückseite 110 her in die Halbleiterschichtenfolge 2 hinein. Er durchdringt die p-leitende Schicht 21 und die aktive Schicht 22 vollständig und verläuft in die n-leitende Schicht 23, insbesondere in den ersten Bereich 231 der n-leitenden Schicht 23, hinein.

In der n-leitenden Schicht 23 beziehungsweise in deren ersten Bereich 231 endet der erste Abschnitt 41 der Vertiefung 4 mit einer Bodenfläche 411. Seitlich ist der erste Abschnitt 41 von Seitenflächen 412A, 412B, 412C und 412D begrenzt, welche die Bodenfläche 411 lateral vollständig umschließen.

Ein Beispiel für eine Variante, bei der der erste Abschnitt 41 vier Seitenflächen 412A, 412B, 412C und 412D hat, ist ein erster Abschnitt 41 mit einer rechteckigen oder quadratischen Grundfläche. Die Seitenflächen 412A, 412B, 412C und 412D stellen dann die Mantelflächen eines Pyramidenstumpfs dar.

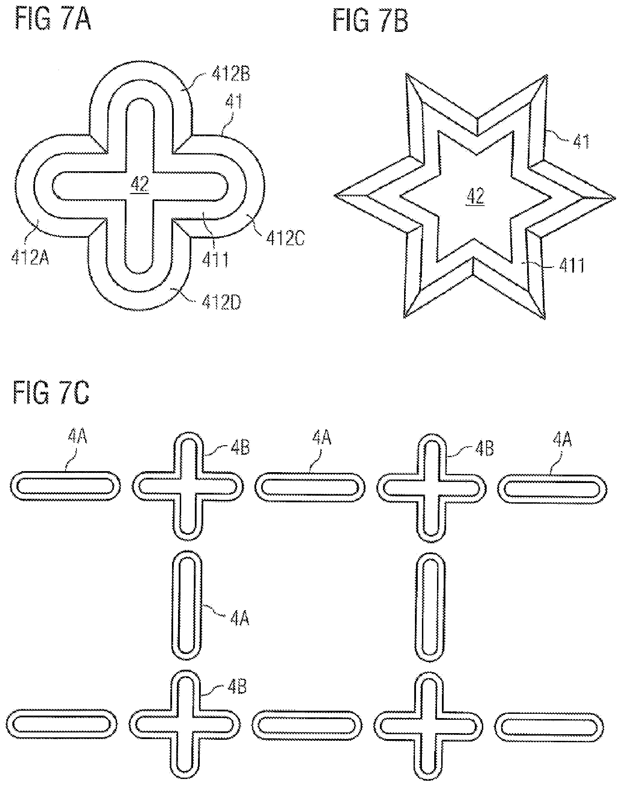

Vorliegend ist die Vertiefung 4 jedoch in Form eines Kreuzes ausgebildet, wie Figur 7A in Draufsicht auf einen Ausschnitt der Rückseite 110 des Halbleiterkörpers 1 gemäß dem ersten Ausführungsbeispiels schematisch zeigt.

Die Seitenflächen 412A, 412B, 412C, 412D sind vorliegend in Draufsicht U-förmig und stoßen jeweils an einem Schenkel des U an eine benachbarte Seitenfläche.

Figur 7B in Draufsicht auf einen Ausschnitt der Rückseite 110 des Halbleiterkörpers 1 eine andere Variante, bei der die Vertiefung einen sternförmigen Querschnitt hat. Bei dieser Variante hat die Vertiefung mehr als vier Seitenflächen. Insbesondere Hat sie zwei Seitenflächen pro Zacke des Sterns.

Je nach Formgebung kann der erste Abschnitt 41 alternativ auch eine einzige Seitenfläche 412 aufweisen, welche die Bodenfläche 412 vollständig umschließt und insbesondere ringförmig ausgebildet ist. Ein Beispiel für eine Variante mit einer einzigen Seitenfläche 412 ist ein erster Abschnitt 41 mit einer kreisförmigen oder ellipsenförmigen Grundfläche. Die Seitenfläche 412 stellt dann beispielsweise die Mantelfläche eines Kegelstumpfs dar.

Figur 7C zeigt eine weitere Variante des Halbleiterkörpers 1 in einer schematischen Draufsicht auf einen Ausschnitt seiner Rückseite 110. Bei dieser Variante weist der Halbleiterkörper eine Mehrzahl von Vertiefungen 4B mit kreuzförmigem Querschnitt auf, die an den Gitterpunkten eines gedachten rechteckigen oder quadratischen Gitters angeordnet sind. Zwischen je zwei der kreuzförmigen Vertiefungen 4B ist eine streifenförmige Vertiefung 4A angeordnet.

Die Seitenflächen 412A, 412B, 412C und 412D des ersten Abschnitts 41 verlaufen bei dem vorliegenden Ausführungsbeispiel schräg zu der Haupterstreckungsebene der Halbleiterschichtenfolge. Die Haupterstreckungsebene ist insbesondere diejenige Ebene, die senkrecht zu einem Abstandsvektor von einer rückseitigen Hauptfläche 101 zu einer vorderseitigen Hauptfläche 102 der Halbleiterschichtenfolge 2 steht. Die Haupterstreckungsebene ist insbesondere parallel zur rückseitigen Hauptfläche 101 und/oder zur vorderseitigen Hauptfläche 102 der Halbleiterschichtenfolge 2.

Ein solcher schräger Verlauf der Seitenflächen 412A-412D kann beispielsweise dadurch erzielt werden, dass die Flanken der Maskenschicht, mittels welchen der erste Abschnitt hergestellt wird, abgerundet werden. Dies kann insbesondere bei einer Fotolackschicht dadurch erfolgen, dass die Fotolackschicht nach dem Fotolithographieschritt zu ihrer Strukturierung erwärmt wird.

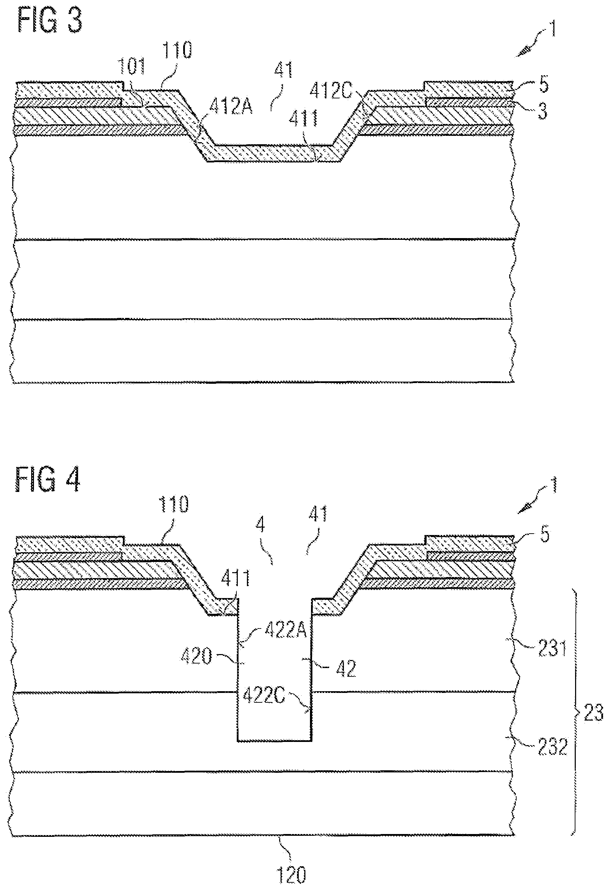

Figur 3 zeigt den optoelektronischen Halbleiterkörper 1 bei einem dritten, nachfolgenden Stadium des Verfahrens. Bei diesem Stadium ist die Rückseite 110 des Halbleiterkörpers 1 mit einer elektrisch isolierenden Schicht 5 überzogen. Die elektrisch isolierende Schicht besteht beispielsweise aus Siliziumdioxid oder aus Siliziumnitrid. Die elektrisch isolierende Schicht 5 überdeckt die p-Kontaktschicht 3, die rückseitige Hauptfläche 101 der Halbleiterschichtenfolge 2 und die Oberfläche des ersten Abschnitts 41 der Vertiefung 4, insbesondere also deren Bodenfläche 411 und deren Seitenflächen 412A-412D.

Figur 4 zeigt ein viertes, nachfolgendes Stadium des Verfahrens zur Herstellung des Halbleiterkörpers 1. Dieses Stadium zeigt den Halbleiterkörper 1, nachdem in einem auf das dritte Stadium nachfolgenden Verfahrensschritt ein zweiter Abschnitt 42 der Vertiefung 4 hergestellt wurde.

Der zweite Abschnitt 42 hat eine Öffnung 420, die vorliegend in der Bodenfläche 411 des ersten Abschnitts 41 enthalten ist. Ausgehend von der Öffnung 420 erstreckt sich der zweite Abschnitt 42 der Vertiefung 4 in Richtung zur Vorderseite 120 des Halbleiterkörpers hin.

Der zweite Abschnitt durchdringt die Halbleiterschichtenfolge 2 nicht vollständig in Richtung zur Vorderseite 120 hin, sondern endet innerhalb der n-leitenden Schicht 23. Vorliegend endet der zweite Abschnitt 42 mit seiner Bodenfläche 421 innerhalb des zweiten Bereichs 232 der n-leitenden Schicht 23. Der zweite Abschnitt 42 verläuft vorliegend vollständig innerhalb der n-leitenden Schicht, also innerhalb der Schicht des zweiten Leitfähigkeitstyps 23.

In Draufsicht auf die Rückseite 110 ist die Öffnung 420 des zweiten Abschnitts vollständig von einer Außenkontur der Bodenfläche 411 des ersten Abschnitts 41 umschlossen. Die Seitenflächen 422A, 422B, 422C und 422D beziehungsweise die Seitenfläche 422 verlaufen vorzugsweise senkrecht oder nahezu senkrecht zur Haupterstreckungsebene des Halbleiterkörpers 1. Insbesondere schließen sie mit der Haupterstreckungsebene einen größeren Winkel ein als die Seitenflächen 412A-412D beziehungsweise die Seitenfläche 412 des ersten Abschnitts 41.

Die Seitenfläche 422 beziehungsweise die Seitenflächen 422A, 422B, 422C und 422D sind von der elektrisch isolierenden Schicht 5 unbedeckt.

In Draufsicht auf die Rückseite 110 ist der Flächeninhalt der Öffnung 420 kleiner als der Flächeninhalt eines von einer Außenkontur des ersten Abschnitts 41 umschlossenen Gebiets. Vorzugsweise ist der Flächeninhalt der Öffnung 420 höchstens halb so groß wie der Flächeninhalt des von der Außenkontur des ersten Abschnitts 41 umschlossenen Gebiets in Projektion auf die Haupterstreckungsebene des Halbleiterkörpers 1.

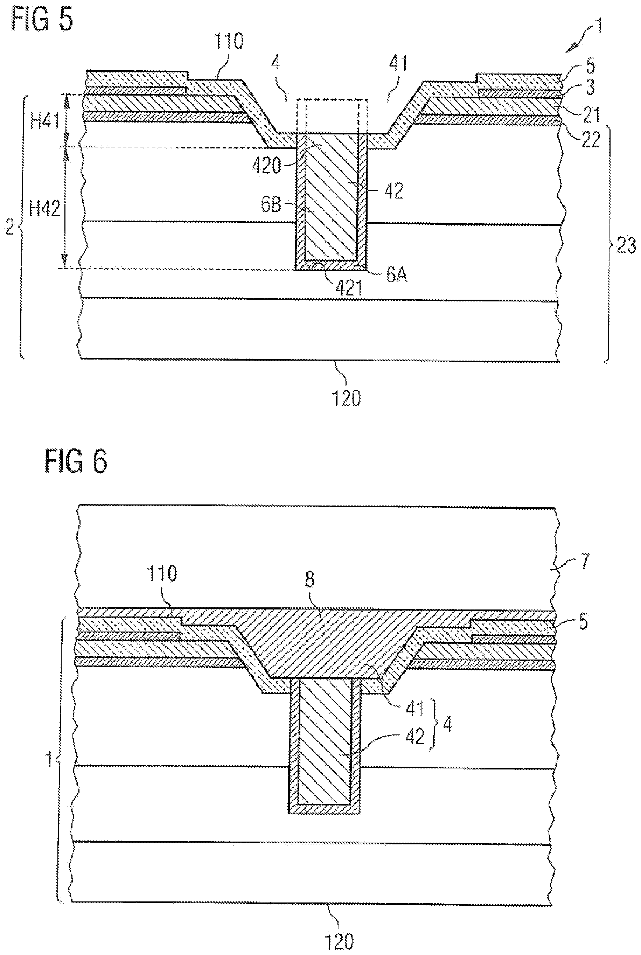

Figur 5 zeigt den optoelektronischen Halbleiterkörper 1 bei einem fünften, nachfolgenden Stadium. In diesem Stadium ist der Halbleiterkörper 1 gemäß dem ersten Ausführungsbeispiel insbesondere fertig gestellt.

Der zweite Abschnitt 42 der Vertiefung 4 ist bei dem fünften Stadium mit einer Metallschicht 6A, 6B gefüllt. Beispielsweise wird zur Herstellung des zweiten Abschnitts 42 eine strukturierte Maskenschicht aufgebracht und die elektrisch isolierende Schicht 5 und die Halbleiterschichtenfolge 2 durch die Maskenschicht hindurch entfernt - etwa mittels Trockenätzen. Bei einer Ausgestaltung wird diese Maskenschicht auch als Maskenschicht für das Abscheiden der Metallschicht 6A, 6B verwendet. So kann auf einfache Weise eine besonders genaue Positionierung der Metallschicht 6A, 6B hinsichtlich des zweiten Abschnitts 42 erzielt werden.

Vorliegend besteht die Metallschicht aus einer Reflektorschicht 6A, welche die Oberfläche des zweiten Abschnitts 42 vollständig bedeckt. Alternativ kann die metallische Reflektorschicht 6A auch nur auf der Bodenfläche 421 des zweiten Abschnitts oder nur auf einen Teilbereich der Bodenfläche 421 aufgebracht sein.

Anders ausgedrückt ist die metallische Reflektorschicht 6A insbesondere in einem Randbereich des zweiten Abschnitts 42 angeordnet, während ein Mittelbereich des zweiten Abschnitts 42 frei von der metallischen Reflektorschicht ist. Der Mittelbereich ist mit einer metallischen Stromverteilungsschicht 6B gefüllt. Diese kann optional weggelassen sein.

Die metallische Reflektorschicht 6A enthält vorzugsweise ein Metall oder eine Legierung mit einem großen Reflexionskoeffizienten. Beispielsweise besteht die metallische Reflektorschicht 6A aus Silber. Die metallische Stromverteilungsschicht 6B kann aus dem gleichen Material bestehen wie die metallische Reflektorschicht 6A. Sie kann auch ein anderes Metall oder eine andere Legierung aufweisen. Beispielsweise besteht die metallische Stromverteilungsschicht 6B aus Gold oder Silber.

Die Metallschicht 6A, 6B braucht den zweiten Abschnitt 42 nicht vollständig zu füllen. Alternativ kann sie auch den zweiten Abschnitt 42 vollständig füllen und über dessen Öffnung 420 in Richtung der Rückseite 110 hinaus und in den ersten Abschnitt 41 hinein ragen. Dies ist in Figur 5 mit den gestrichelten Linien angedeutet. Beispielsweise ragt die Metallschicht 6A, 6B säulenartig in den ersten Abschnitt 41 hinein, so dass sie einen Mittelbereich des ersten Abschnitts 41 füllt und einen um den Mittelbereich umlaufenden Randbereich des ersten Abschnitts 41 frei lässt.

Figur 6 zeigt ein erstes Ausführungsbeispiel eines optoelektronischen Halbleiterchips in einer schematischen Querschnittsdarstellung.

Der optoelektronische Halbleiterchip enthält einen optoelektronischen Halbleiterkörper 1, beispielsweise vorliegend einen optoelektronischen Halbleiterkörper 1 gemäß dem ersten Ausführungsbeispiel, wie er in Figur 5 dargestellt ist. Zusätzlich enthält der Halbleiterchip eine Trägerplatte 7, beispielsweise aus Ge oder Si.

Der Halbleiterkörper 1 ist mit seiner Rückseite 110 an der Trägerplatte 7 mittels eines Lötmetalls 8 befestigt. Das Lötmetall füllt die Vertiefung 8 auf. Anders ausgedrückt sind die von der Metallschicht 6A, 6B und der elektrisch isolierenden Schicht 5 freien Bereiche der Vertiefung 4 mit dem Lötmetall 8 gefüllt, insbesondere vollständig gefüllt.

Erstreckt sich die Metallschicht 6A, 6B über die Öffnung 420 des zweiten Abschnitts der Vertiefung 4 hinaus in den ersten Abschnitt 41 hinein, wie in Zusammenhang mit der Figur 5 erläutert, füllt das Lötmetall insbesondere den Randbereich des ersten Abschnitts 41. Ist der zweite Abschnitt 42 nicht vollständig von der Metallschicht 6A, 6B gefüllt, ist der von der Metallschicht 6A, 6B freie Bereich 42 des zweiten Abschnitts ebenfalls mit dem Lötmetall gefüllt. Der freie, mit Lötmetall gefüllte Bereich der Vertiefung 4 hat bei dem vorliegenden Ausführungsbeispiel ein Volumen von kleiner oder gleich 500 µm³. Beispielsweise zwischen 500 µm³ und 300 µm³, wobei die Grenzen eingeschlossen sind.

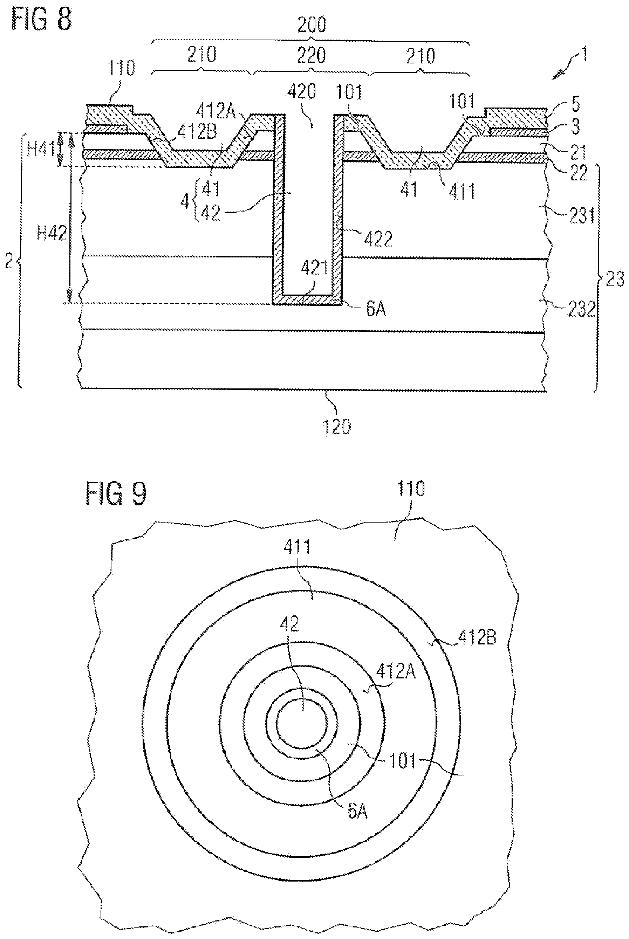

Figur 8 zeigt einen schematischen Querschnitt durch einen optoelektronischen Halbleiterkörper gemäß einem zweiten Ausführungsbeispiel. Figur 9 zeigt eine schematische Draufsicht auf einen Ausschnitt des Halbleiterkörpers gemäß dem zweiten Ausführungsbeispiel auf seine Rückseite 110.

Im Unterschied zum ersten Ausführungsbeispiel erstreckt sich bei dem Halbleiterkörper 1 gemäß dem zweiten Ausführungsbeispiel der zweite Abschnitt 42 der Vertiefung 4 nicht ausgehend von einer Bodenfläche 411 des ersten Abschnitts 41 in Richtung der Vorderseite 120 in die Halbleiterschichtenfolge 2 hinein. Vielmehr überlappen der erste Abschnitt 41 und der zweite Abschnitt 42 der Vertiefung 4 in Draufsicht auf die Rückseite 110 des Halbleiterkörpers 1 nicht.

Stattdessen verläuft der erste Abschnitt 41 ringförmig um den zweiten Abschnitt 42 herum. Der erste Abschnitt 41 hat die Form einer Rinne, welche den zweiten Abschnitt 42 in Draufsicht auf die Rückseite 110 vollständig umschließt.

Auf diese Weise umschließt in Draufsicht auf die Rückseite 110 eine Außenkontur des ersten Abschnitts 41 ein Gebiet 200 der Halbleiterschichtenfolge 2. Das Gebiet 200 hat einen Randbereich 210, in welchem der erste Abschnitt 41 der Vertiefung 4 angeordnet ist. Der Randbereich 210 umschließt einen Mittelbereich 220 des Gebiets 200 vollständig, in welchem der zweite Abschnitt 42 angeordnet ist.

Der zweite Abschnitt 42 verläuft bei dem vorliegenden Ausführungsbeispiel von einer Öffnung 420 in der ersten Hauptfläche 101 der Halbleiterschichtenfolge 2 durch die Schicht des ersten Leitfähigkeitstyps 21 und durch die aktive Schicht 22 hindurch und in die Schicht des zweiten Leitfähigkeitstyps 23 hinein. Insbesondere verläuft sie durch den ersten Bereich 231 der Schicht des zweiten Leitfähigkeitstyps 23 hindurch bis in den zweiten, stark dotierten Bereich 232 der Schicht 23 des zweiten Leitfähigkeitstyps hinein.

Vorliegend ist die Oberfläche des zweiten Abschnitts 42 mit einer reflektierenden Metallschicht 6A bedeckt. Diese schließt im Mittelbereich 220 des von der Außenkontur des ersten Abschnitts 41 umschlossenen Gebiets 200 die aktive Schicht 22 kurz. Mittels des ersten Abschnitts 41 ist der im Mittelbereich 220 angeordnete Teil der aktiven Schicht 22 jedoch von dem außerhalb des Gebiets 200 angeordneten Teil der aktiven Schicht 22 abgetrennt. Der Kurzschluss der aktiven Schicht 22 in dem Mittelbereich 220 spielt deshalb für die Funktionsfähigkeit des Halbleiterkörpers keine Rolle.

Wie beim ersten Ausführungsbeispiel braucht die reflektierende Metallschicht 6A die Oberfläche des zweiten Abschnitts 42 nicht vollständig zu bedecken. Wie beim ersten Ausführungsbeispiel kann auch bei diesem Ausführungsbeispiel vorgesehen sein, das zumindest ein vorderseitiges Teilstück des zweiten Abschnitts 42 oder der gesamte zweite Abschnitt vollständig mit der Metallschicht 6A, 6B gefüllt ist.
Bei den Halbleiterkörpern gemäß dem ersten und dem zweiten Ausführungsbeispiel ist die Tiefe H41 des ersten Abschnitts möglichst gering, so dass beim Befestigen an einer Trägerplatte 7 eines Halbleiterchips wie er beispielsweise in Figur 6 dargestellt ist, ein möglichst geringes Volumen mit dem Lötmetall 8 zu füllen ist. Beispielsweise hat die Tiefe H41 des ersten Abschnitts 41 einen Wert zwischen 200 nm und 500 nm, wobei die Grenzen eingeschlossen sind. Zweckmäßigerweise ist jedoch die Tiefe H41 so groß gewählt, dass die aktive Schicht 21 vollständig durchtrennt wird. So wird mit Vorteil die Gefahr eines Kurzschlusses der aktiven Schicht durch die Metallschicht 6A, 6B - insbesondere außerhalb des Mittelbereichs 220 des von der Außenkontur des ersten Abschnitts 41 umschlossenen Gebiets 200 - verringert.
Die Tiefe H42 des zweiten Abschnitts ist vorzugsweise größer als die Tiefe H41 des ersten Abschnitts. Beispielsweise ist sie größer oder gleich 1 µm.

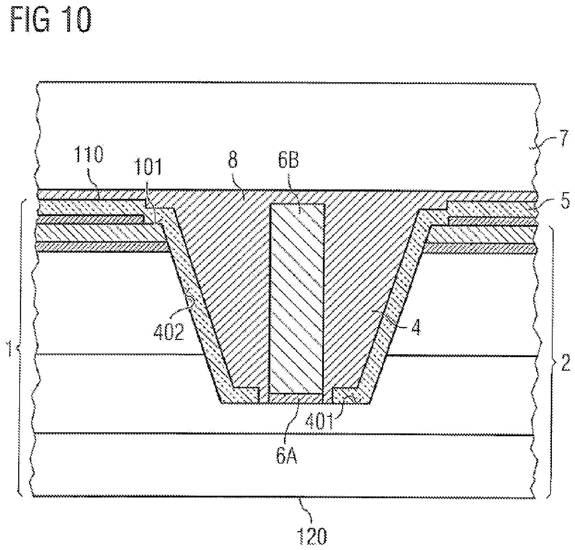

Figur 10 zeigt einen schematischen Querschnitt durch einen optoelektronischen Halbleiterchip gemäß einem ersten, nicht zur Erfindung gehörenden Erläuterungsbeispiel. Der Halbleiterchip gemäß dem nicht zur Erfindung gehörenden ersten Erläuterungsbeispiel der Figur 10 unterscheidet sich dadurch von demjenigen des ersten exemplarischen Ausführungsbeispiels, dass die Vertiefungen 4 des Halbleiterkörpers 1 keine der Erfindung entsprechenden unterschiedlich geformten ersten und zweiten Abschnitte 41, 42 aufweisen. Stattdessen erstreckt sich die, vorliegend ringförmig umlaufende Seitenfläche 402 der Vertiefung 4 als glatte Fläche - also insbesondere ohne Kanten und Knicke - von der rückseitigen Hauptfläche 101 der Halbleiterschichtenfolge 2 bis zur vorderseitigen Bodenfläche 401 der Vertiefung 4.

Die Seitenfläche 402 der Vertiefung ist vollständig mit elektrisch isolierenden Schicht 5 überzogen. Zumindest ein Teilbereich, vorliegend ein mittlerer Bereich, der Bodenfläche 401 ist frei von der elektrisch isolierenden Schicht 5.

Ein Teilstück der Bodenfläche 401 ist mit einer Metallschicht, die vorliegend aus einer metallischen Reflektorschicht 6A und einer metallischen Stromverteilungsschicht 6B besteht, bedeckt. Die Schicht des zweiten Leitfähigkeitstyps 23 ist mittels der Metallschicht 6A, 6B durch die Vertiefung 4 hindurch elektrisch angeschlossen.

Von der Bodenfläche 401 der Vertiefung 4 ausgehend erstreckt sich die metallische Schicht in Richtung zur Rückseite 110 hin. Die Metallschicht 6A, 6B füllt vorzugsweise mindestens ein Drittel des Volumens der Vertiefung 4. Das restliche Volumen der Vertiefung, vorliegend ein um die Metallschicht 6A, 6B umlaufender Randbereich der Vertiefung 4 ist mit dem Lötmetall 8 gefüllt, mittels welchem der Halbleiterkörper 1 an der Trägerplatte 7 befestigt ist.

Beispielsweise wird die elektrisch isolierende Schicht 5 zunächst auf der gesamten Oberfläche der Vertiefung 4 abgeschieden und mit Hilfe einer strukturierten Maskenschicht von dem Teilbereich der Bodenfläche 401 entfernt. Diese Maskenschicht kann bei einer Ausgestaltung während des Abscheidens der Metallschicht 6A, 6B weiter verwendet werden, um die Metallschicht 6A, 6B auf dem mittleren Bereich der Bodenfläche 401 abzuscheiden und den Randbereich der Vertiefung 4 von der Metallschicht 6A, 6B frei zu halten. Zwischen der Metallschicht 6A, 6B und dem Lötmetall 8 kann eine Lötstoppschicht (in Figur 10 nicht gezeigt) angeordnet sein. Die Lötstoppschicht besteht beispielsweise aus TiWN. Sie verringert mit Vorteil die Gefahr, dass sich das Material der Metallschicht 6A, 6B mit dem Lötmetall 8 vermischt. Die Lötstoppschicht kann auch auf die elektrisch isolierende Schicht und/oder gegebenenfalls auf einen von der Metallschicht 6A, 6B und der elektrisch isolierenden Schicht 5 unbedeckten Bereich der Oberfläche der Halbleiterschichtenfolge, insbesondere im Bereich der Bodenfläche 401 der Vertiefung 4, angeordnet sein.

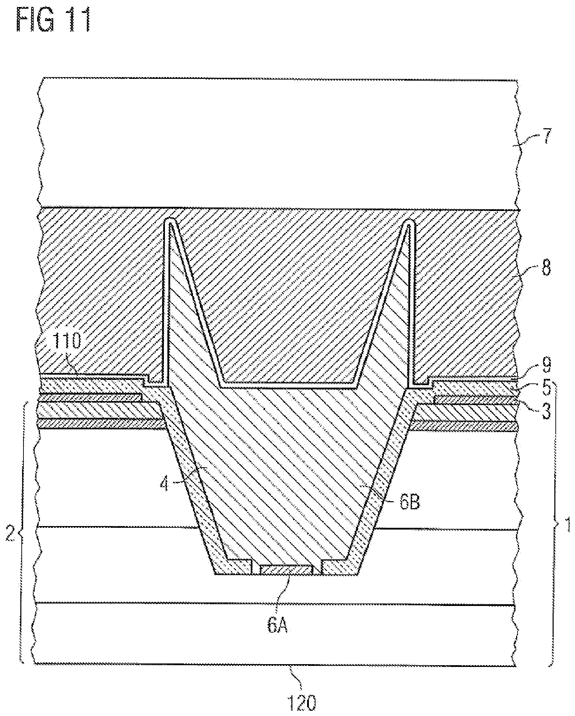

Figur 11 zeigt ein zweites nicht zur Erfindung gehörendes Erläuterungsbeispiel eines optoelektronischen Halbleiterchips. Das zweite Erläuterungsbeispiel des Halbleiterchips unterscheidet sich vom ersten Erläuterungsbeispiel des Halbleiterchips dadurch, dass die Vertiefung 4 vollständig mit der Metallschicht 6A, 6B gefüllt ist.
Wird eine strukturierte Maskenschicht verwendet, um einen die elektrisch isolierende Schicht 5 von einem Teilbereich der Bodenfläche 401 zu entfernen, wird diese bei dem vorliegenden Ausführungsbeispiel vor dem Abscheiden der Metallschicht 6A, 6B entfernt. Um die Metallschicht 6A, 6B lateral auf den Bereich der Vertiefung 4 zu begrenzen kann die Abscheidung der Metallschicht 6A, 6B unter Zuhilfenahme einer weiteren strukturierten Maskenschicht erfolgen.
Ein vorliegend ringförmiges Teilstück der metallischen Stromverteilungsschicht 6B ragt in Richtung der Rückseite 110 über die Halbleiterschichtenfolge 2 hinaus. Es ist auch vorstellbar, dass die Metallschicht 6A, 6B die Vertiefung 4 vollständig ausfüllt, jedoch nicht in Richtung der Rückseite 110 über die Halbleiterschichtenfolge 2, über die erste Kontaktschicht 3, oder über die elektrisch isolierende Schicht 5 hinausragt.

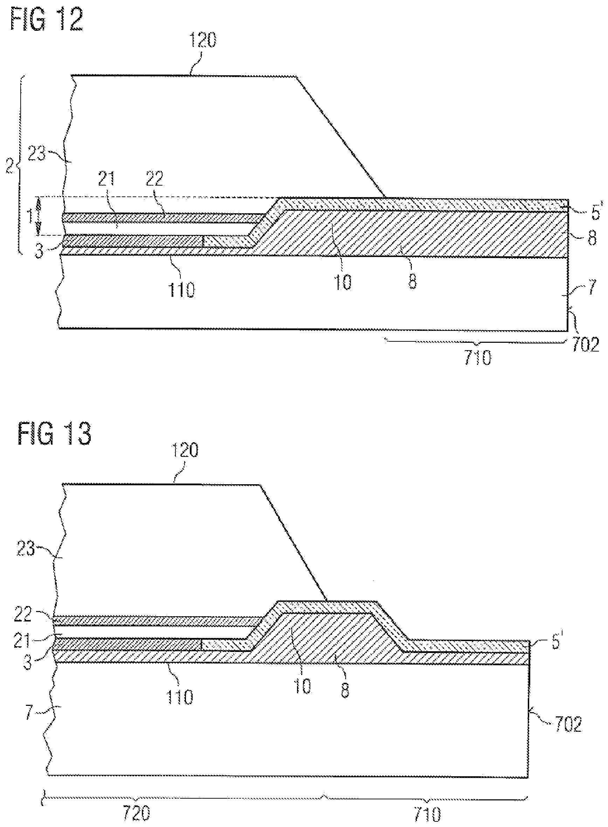

Bei dem vorliegenden zweiten Erläuterungsbeispiel des Halbleiterchips ist der Halbleiterkörper 1 an seiner Rückseite 110 an allen Stellen, an denen er in Draufsicht auf die Rückseite 110 mit der Trägerplatte 7 überlappt, mit einer Lötstoppschicht 9 überzogen, wie sie bereits im Zusammenhang mit dem zweiten Ausführungsbeispiel des Halbleiterchips beschrieben ist. Insbesondere ist die Lötstoppschicht 9 über der gesamten rückseitigen Oberfläche des Halbleiterkörpers 1 angeordnet. Figur 12 zeigt einen schematischen Querschnitt eines Randbereichs eines optoelektronischen Halbleiterchips gemäß einem dritten, nicht zur Erfindung gehörenden Erläuterungsbeispiel. Der Halbleiterchip enthält einen Halbleiterkörper 1, der eine aktive Halbleiterschichtenfolge 2 aufweist, welche in Richtung von der Rückseite 110 zur Vorderseite 120 hin die Schicht des ersten Leitfähigkeitstyps, insbesondere die p-leitende Schicht 21, die aktive Schicht 22 und die Schicht des zweiten Leitfähigkeitstyps, insbesondere n-leitende Schicht 23, enthält. Vorzugsweise enthält der Halbleiterkörper 1 auch Vertiefungen 4, wie in Zusammenhang mit dem ersten und zweiten Ausführungsbeispiel des Halbleiterkörpers in Zusammenhang mit den Figuren 1-5 beziehungsweise 8-9 beschrieben.
Die n-leitende Schicht 23 ragt bei dem vorliegenden Ausführungsbeispiel seitlich über die p-leitende Schicht 21 und über die aktive Schicht 22 hinaus. Zusammen mit der Trägerplatte 7 bildet die n-leitende Schicht 23 auf diese Weise eine Nut 10, die seitlich um die Halbleiterschichtenfolge 2 umläuft. Die Nut 10 ist mit dem Lötmetall 8 gefüllt.
Im Bereich der Nut 10 ist die Halbleiterschichtenfolge 2 - insbesondere die p-leitende Schicht 21 und die aktive Schicht 22 - mit einer Passivierungsschicht 5' bedeckt. Enthält die Halbleiterschichtenfolge 2 Vertiefungen 4, welche mit einer elektrisch isolierenden Schicht 5 zumindest teilweise ausgekleidet sind, können die elektrisch isolierende Schicht 5 und die Passivierungsschicht 5' Teilbereiche ein und derselben Schicht darstellen.
Die Tiefe H41 der Nut 10 - das ist ihre Ausdehnung in Richtung von der Rückseite 110 zur Vorderseite 120 - ist vorzugsweise möglichst gering, so dass das Lötmetall 8 ein vergleichsweise geringes Volumen füllen muss. Sie ist jedoch derart gewählt, dass sich die Nut 10 in Richtung von der Rückseite 110 zur Vorderseite 120 hin über die aktive Schicht 22 hinaus erstreckt. Insbesondere hat die Nut 10 die gleiche Tiefe H41 wie der erste Abschnitt 41 der Vertiefung 4.

Bei dem vorliegenden Erläuterungsbeispiel erstreckt sich die Passivierungsschicht 5' seitlich über die Halbleiterschichtenfolge 2 hinaus. Die Trägerplatte 7 ragt ebenfalls seitlich über die Halbleiterschichtenfolge 2 hinaus so dass in Draufsicht auf die Vorderseite 120 ein Randbereich der Trägerplatte 7 frei von der Halbleiterschichtenfolge ist. Vorliegend erstreckt sich die Passivierungsschicht 5' über den gesamten Randbereich 710 der Trägerplatte 7. Auf diese Weise ist die Nut 10 seitlich über die Halbleiterschichtenfolge 2 hinaus verlängert und wird im Randbereich 710 der Trägerplatte 7 von der Trägerplatte 7 und der Passivierungsschicht 5' begrenzt. Vorliegend erstreckt sich die Nut 10 bis zu einer Seitenkante 702 der Trägerplatte hin.
Figur 13 zeigt einen schematischen Querschnitt durch einen Randbereich eines optoelektronischen Halbleiterchips gemäß einem vierten nicht zur Erfindung gehörenden Erläuterungsbeispiel. Im Verlauf in der Richtung von einem Mittelbereich 720 zum Randbereich 710 der Trägerplatte 7 hin verläuft - im Gegensatz zum Ausführungsbeispiel der Figur 12 - bei dem Halbleiterchip gemäß dem Erläuterungsbeispiel der Figur 13 die Passivierungsschicht 5' zunächst zur Bildung der Nut zwischen der Trägerplatte 7 und der Halbleiterschichtenfolge 2 in Richtung der Vorderseite 120 von der Trägerplatte weg. Im weiteren Verlauf in der Richtung von einem Mittelbereich 720 zum Randbereich 710 der Trägerplatte 7 hin verläuft sie seitlich von der Halbleiterschichtenfolge 2 nachfolgend wieder in Richtung der Rückseite 110 zu der Trägerplatte 7 hin. Die Nut 10 ist auf diese Weise bei dem vorliegenden Erläuterungsbeispiel seitlich über die Halbleiterschichtenfolge 2 hinaus verlängert, jedoch erstreckt sie sich nicht bis zur Seitenkante 702 der Trägerplatte 7, sondern erstreckt sich nur über ein Teilgebiet des Randbereichs 710 der Trägerplatte 7.

## Patentansprüche

1. Optoelektronischer Halbleiterchip umfassend eine Trägerplatte (7) und einen optoelektronischen Halbleiterkörper (1) mit
- einer Vorderseite (120), die zur Emission und/oder zum Empfang von elektromagnetischer Strahlung vorgesehen ist,
- einer der Vorderseite (120) gegenüberliegenden Rückseite (110), und
- die Rückseite (110) des optoelektronischen Halbleiterkörpers (1) der Trägerplatte (7) zugewandt ist, wobei der optoelektronische Halbleiterkörper (1) mittels eines Metalls (8) an der Trägerplatte (7) befestigt ist, und
- das Metall (8) zumindest einen ersten Abschnitt (41) einer Vertiefung (4) ausfüllt;
- einer aktiven Halbleiterschichtenfolge (2) die in Richtung von der Rückseite (110) zur Vorderseite (120) eine Schicht eines ersten Leitfähigkeitstyps (21), eine aktive Schicht (22) und eine Schicht eines zweiten Leitfähigkeitstyps (23) in dieser Reihenfolge aufweist, wobei
- die Halbleiterschichtenfolge (2) mindestens die Vertiefung (4) aufweist, die sich von der Rückseite (110) her in die Halbleiterschichtenfolge (2) hinein erstreckt, wobei die Vertiefung (4) in einer lateralen Richtung parallel zur Haupterstreckungsrichtung der Halbleiterschichtenfolge (2) vollständig von einer kontinuierlichen Bahn der aktiven Schicht (22) umschlossen ist;
- die Vertiefung (4) den ersten Abschnitt (41) aufweist, welcher durch die Schicht des ersten Leitfähigkeitstyps (21) und die aktive Schicht (22) hindurch in die Schicht des zweiten Leitfähigkeitstyps (23) hinein verläuft und in der Schicht des zweiten Leitfähigkeitstyps (23) eine Bodenfläche (411) aufweist;
- die Vertiefung (4) einen zweiten Abschnitt (42) mit einer Öffnung (420) aufweist, wobei in der lateralen Richtung die Öffnung (420) nicht vollständig einen Bereich der aktiven Schicht (22) umschließt und wobei die Öffnung (420) in Draufsicht auf die Rückseite (110) von einer Außenkontur der Bodenfläche (411) des ersten Abschnitts (41) vollständig umschlossen ist und der zweite Abschnitt (42) sich ausgehend von der Öffnung (420) in Richtung zur Vorderseite (120) hin erstreckt und zumindest in der Schicht des zweiten Leitfähigkeitstyps (23) verläuft, **dadurch gekennzeichnet dass**
das Metall ein Lötmetall ist.

2. Optoelektronischer Halbleiterchip nach Anspruch 1, wobei die Öffnung (420) des zweiten Abschnitts (42) in der Bodenfläche (411) des ersten Abschnitts (41) enthalten ist und der zweite Abschnitt (42) vollständig innerhalb der Schicht des zweiten Leitfähigkeitstyps (23) verläuft.

3. Optoelektronischer Halbleiterchip nach Anspruch 1, wobei der erste Abschnitt (41) als Rinne ausgebildet ist, die um die Öffnung (420) des zweiten Abschnitts (42) herum verläuft, und der zweite Abschnitt (42) durch die Schicht des ersten Leitfähigkeitstyps (21) und die aktive Schicht (22) hindurch in die Schicht des zweiten Leitfähigkeitstyps (23) hinein verläuft.

4. Optoelektronischer Halbleiterchip nach einem der vorhergehenden Ansprüche, wobei eine Seitenfläche (412, 412A, 412B, 412C, 412D) des ersten Abschnitts (41) schräg zu einer Haupterstreckungsebene der Halbleiterschichtenfolge (2) verläuft.

5. Optoelektronischer Halbleiterchip nach einem der vorhergehenden Ansprüche, wobei der zweite Abschnitt (42) zumindest teilweise mit einer Metallschicht (6A, 6B) gefüllt ist.

6. Optoelektronischer Halbleiterchip nach einem der vorhergehenden Ansprüche, wobei eine Oberfläche des ersten Abschnitts (41) zumindest stellenweise mit einer elektrisch isolierenden Schicht (5) überzogen ist und die Oberfläche des zweiten Abschnitts (42) frei von einer elektrisch isolierenden Schicht ist.

7. Optoelektronischer Halbleiterchip nach einem der vorhergehenden Ansprüche, wobei ein vollständig um die Öffnung (420) des zweiten Abschnitts (42) umlaufender Bereich der Bodenfläche (411) des ersten Abschnitts (41) eine minimale laterale Ausdehnung von größer oder gleich 1 µm hat.

## Claims

1. An optoelectronic semiconductor chip comprising a carrier plate (7) and an optoelectronic semiconductor body (1) having
- a front side (120) intended for emitting and/or receiving electromagnetic radiation,
- a rear side (110) opposite the front side (120), and
- the rear side (110) of the optoelectronic semiconductor body (1) faces the carrier plate (7), the optoelectronic semiconductor body (1) being attached to the carrier plate (7) by means of a metal (8), and
- the metal (8) fills at least a first portion (41) of a recess (4);
- an active semiconductor layer sequence (2) comprising, in the direction from the rear side (110) to the front side (120), a layer of a first conductivity type (21), an active layer (22) and a layer of a second conductivity type (23) in this order,
wherein
- the semiconductor layer sequence (2) comprises at least the recess (4) extending into the semiconductor layer sequence (2) from the rear side (110), wherein the recess (4) is completely enclosed by a continuous path of the active layer (22) in a lateral direction parallel to the main direction of extension of the semiconductor layer sequence (2);
- said recess (4) comprises said first portion (41) which extends through the layer of the first conductivity type (21) and the active layer (22) into the layer of the second conductivity type (23) and has a bottom surface (411) in the layer of the second conductivity type (23);
- the recess (4) comprises a second portion (42) with an opening (420), wherein in the lateral direction the opening (420) does not completely enclose an area of the active layer (22) and wherein the opening (420) is completely enclosed by an outer contour of the bottom surface (411) of the first portion (41) in plan view of the rear side (110) and the second portion (42) extends from the opening (420) in the direction towards the front side (120) and runs at least in the layer of the second conductivity type (23), **characterized in that** the metal is a solder.

2. The optoelectronic semiconductor chip according to claim 1, wherein the opening (420) of the second portion (42) is contained in the bottom surface (411) of the first portion (41) and the second portion (42) extends completely within the layer of the second conductivity type (23).

3. The optoelectronic semiconductor chip according to claim 1, wherein the first portion (41) is formed as a groove extending around the opening (420) of the second portion (42), and the second portion (42) extends through the layer of the first conductivity type (21) and the active layer (22) into the layer (23) of the second conductivity type.

4. The optoelectronic semiconductor chip according to any of the preceding claims, wherein a side surface (412, 412A, 412B, 412C, 412D) of said first portion (41) is inclined to a main plane of extension of said semiconductor layer sequence (2).

5. The optoelectronic semiconductor chip according to any of the preceding claims, wherein the second portion (42) is at least partially filled with a metal layer (6A, 6B) .

6. The optoelectronic semiconductor chip according to any of the preceding claims, wherein a surface of the first portion (41) is coated at least in places with an electrically insulating layer (5) and the surface of the second portion (42) is free of an electrically insulating layer.

7. The optoelectronic semiconductor chip according to any of the preceding claims, wherein an area of the bottom surface (411) of the first portion (41) which completely surrounds the opening (420) of the second portion (42) has a minimum lateral extent of greater than or equal to 1 µm.

## Revendications

1. Puce semi-conductrice optoélectronique comprenant une plaque de support (7) et un corps semi-conducteur optoélectronique (1) doté
- d'une face recto (120) prévue pour l'émission et/ou la réception de rayonnement électromagnétique,
- d'une face verso (110) opposée à la face recto (120), et
- ladite face verso (110) du corps semi-conducteur optoélectronique (1) étant tournée vers la plaque de support (7), le corps semi-conducteur optoélectronique (1) étant fixé à la plaque de support (7) au moyen d'un métal (8), et
- ledit métal (8) remplissant au moins une première partie (41) d'un renfoncement (4) ;
- d'une série de couches semi-conductrices actives (2) qui présente dans le sens allant de la face verso (110) à la face recto (120) une couche d'un premier type de conductivité (21), une couche active (22) et une couche d'un deuxième type de conductivité (23) dans cet ordre, dans lequel
- la série de couches semi-conductrices (2) présente au moins le renfoncement (4) qui s'étend à partir de la face verso (110) jusque dans la série de couches semi-conductrices (2), ledit renfoncement (4) étant intégralement entouré d'une voie continue de la couche active (22), dans un sens latéral parallèle au sens d'extension principale de la série de couches semi-conductrices (2),
- le renfoncement (4) présente la première partie (41) qui passe au travers de la couche du premier type de conductivité (21) et de la couche active (22) jusque dans la couche du deuxième type de conductivité (23) et qui présente une surface au sol (411) dans la couche du deuxième type de conductivité (23) ;
- le renfoncement (4) présente une deuxième partie (42) dotée d'une ouverture (420), ladite ouverture (420) n'entourant pas intégralement, dans le sens latéral, une zone de la couche active (22) et l'ouverture (420) étant, en vue du dessus sur la face verso (110), intégralement entourée d'un contour extérieur de la surface au sol (411) de la première partie (41), et la deuxième partie (42) s'étirant, à partir de l'ouverture (420) vers la face recto (120) et passant au moins dans la couche du deuxième type de conductivité (23), **caractérisé en ce que** le métal est un métal de brasage.

2. Puce semi-conductrice optoélectronique selon la revendication 1, l'ouverture (420) de la deuxième partie (42) étant contenue dans la surface au sol (411) de la première partie (41) et la deuxième partie (42) passant intégralement à l'intérieur de la couche du deuxième type de conductivité (23).

3. Puce semi-conductrice optoélectronique selon la revendication 1, la première partie (41) étant réalisée sous forme de gorge qui passe autour de l'ouverture (420) de la deuxième partie (42), et la deuxième partie (42) passant au travers de la couche du premier type de conductivité (21) et de la couche active (22) jusque dans la couche du deuxième type de conductivité (23).

4. Puce semi-conductrice optoélectronique selon l'une quelconque des revendications précédentes, une surface latérale (412, 412A, 412B, 412C, 412D) de la première partie (41) étant oblique par rapport à un plan d'extension principale de la série de couches semi-conductrices (2).

5. Puce semi-conductrice optoélectronique selon l'une quelconque des revendications précédentes, la deuxième partie (42) étant remplie au moins partiellement d'une couche de métal (6A, 6B).

6. Puce semi-conductrice optoélectronique selon l'une quelconque des revendications précédentes, une surface de la première partie (41) étant au moins partiellement recouverte d'une couche (5) électriquement isolante et la surface de la deuxième partie (42) étant exempte d'une couche électriquement isolante.

7. Puce semi-conductrice optoélectronique selon l'une quelconque des revendications précédentes, une zone de la surface au sol (411) de la première partie (41) qui entoure intégralement l'ouverture (420) de la deuxième partie (42), ayant un allongement latéral minimum supérieur ou égal à 1 µm.
